# EUROPÄISCHE PATENTSCHRIFT

(11) **EP 1 697 175 B1**
(45) Veröffentlichungstag und Bekanntmachung des Hinweises auf die Patenterteilung: **15.09.2010**
(21) Anmeldenummer: 04762379.8
(22) Anmeldetag: 13.07.2004
(51) Int. Cl.: B60R 16/02, H05K 5/00

(54) **STEUERGERÄTEEINHEIT UND VERFAHREN ZUR HERSTELLUNG DERSELBEN**
CONTROL UNIT AND METHOD FOR PRODUCING THE SAME
UNITE APPAREIL DE COMMANDE ET SON PROCEDE DE PRODUCTION

(30) Priorität: 05.09.2003 DE 10340974
(43) Veröffentlichungstag der Anmeldung: 06.09.2006
(73) Patentinhaber: ROBERT BOSCH GMBH, 70442 Stuttgart (DE)
(72) Erfinder: WETZEL, Gerhard, 70825 Korntal-Muenchingen (DE)
(86) Internationale Anmeldenummer: PCT/DE2004/001519
(87) Internationale Veröffentlichungsnummer: WO 2005/025940

(56) Entgegenhaltungen:
- EP-A- 0 309 920
- DE-A- 10 217 101

## Beschreibung

### STAND DER TECHNIK

Die vorliegende Erfindung betrifft eine Steuergeräteeinheit, insbesondere im Kraftfahrzeugbereich gemäß dem Oberbegriff des Anspruchs 1 und ein Verfahren zur Herstellung der Steuergeräteeinheit.

Das Dokument EP 0309 920 A offenbart den Oberbegriff des Anspruchs 1.

Steuergeräteeinheiten unterliegen insbesondere im Kraftfahrzeugbereich hohen mechanischen Belastungen infolge von Schwingungsbeanspruchungen.

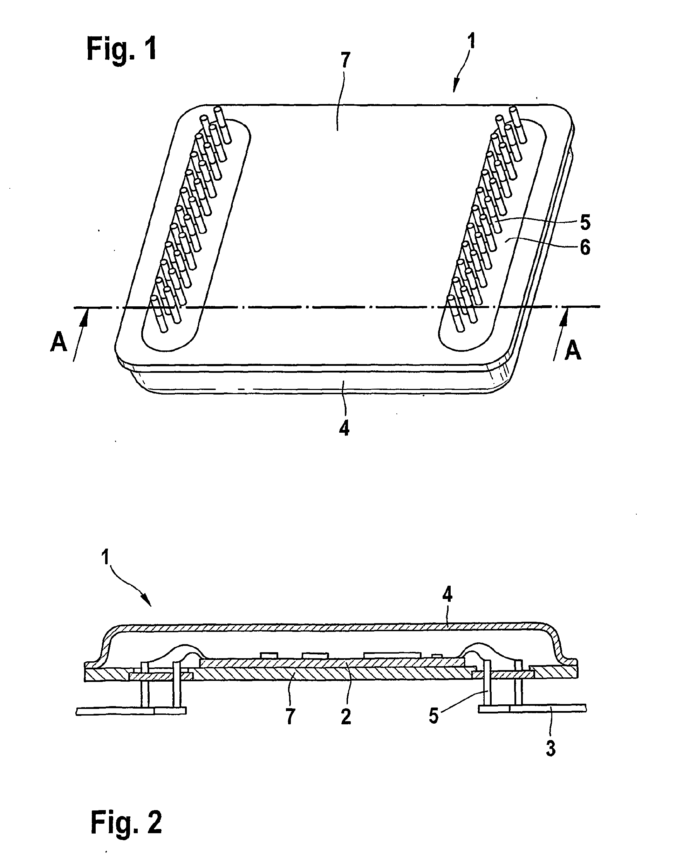

Beispielsweise werden Steuergeräteeinheiten im Kraftfahrzeugbereich für eine Getriebesteuerung verwendet. Anhand der Figuren 1 und 2 soll im folgenden eine Steuergeräteeinheit gemäß dem Stand der Technik erläutert werden, wobei Figur 1 eine Unteransicht einer herkömmlichen Steuergeräteeinheit und Figur 2 eine Seitenquerschnittsansicht des herkömmlichen Steuergerätes entlang der Linie A-A in Figur 1 darstellen.

Die Steuergeräteeinheit 1 enthält beispielsweise ein Hybridsteuergerät 2, Sensoren und mindestens eine Steckverbindung zum Anschluß an einen Fahrzeugkabelbaum bzw. einen Getriebestecker. Die elektrische Verbindung zwischen dem Hybridsteuergerät 2, den Sensoren und dem Getriebestecker erfolgt mittels eines Stanzgitters 3. Die Steuergeräteeinheit 1 weist einen Deckel 4 auf, welcher einen Verschluß der Steuergeräteeinheit 1 gewährleisten soll. Ferner ist in dem Gehäuse die elektronische Schaltung auf dem Hybridsteuergerät 2 vorgesehen. An der Unterseite der Steuergeräteeinheit 1 sind für eine elektrische Kontaktierung zwischen der elektronischen Schaltung und dem Stanzgitter 3 verglaste Stifte 5 angeordnet, welche auf einer Stiftleiste 6 montiert sind. Die elektrische Kontaktierung des Schaltungsträgers mit den verglasten Stiften 5 erfolgt mittels Bonden und die Kontaktierung der verglasten Stifte 5 mit dem Stanzgitter 3 mittels Laser-Schweißen.

In verschiedenen Anwendungsbereichen, beispielsweise in ABS-Systemen, werden Steuergerätegehäuse verwendet, bei denen die Leiterbahnen zur Kontaktierung der Schaltung in ein Kunststoffgehäuse eingespritzt werden, in welchem die elektronische Schaltung vorgesehen ist. Das Gehäuse wird herkömmlich durch einen Deckel 4 verschlossen, welcher entweder auf den Träger der Steuergeräteeinheit geklebt oder eingegossen wird.

Als nachteilig bei dem obigen bekannten Ansatz hat sich die Tatsache herausgestellt, daß die in den Kunststoff eingespritzten Leiterbahnen nicht vollständig abdichtbar sind.

Daher finden sich im Stand der Technik verschiedene Ansätze, die Dichtheit zwischen den Leiterbahnen und dem Kunststoff zu verbessern. Beispielsweise werden die Leiterbahnen in Form von Stiften in den Kunststoff eingepreßt, wobei die Stifte eine genau definierte Form mit hoher Präzision aufweisen müssen.

Ein weiterer Ansatz sieht vor, daß jede Leiterbahn mit einem elastischen Werkstoff umgeben wird, welcher die Dichtfunktion übernehmen soll.

Beide Lösungen weisen jedoch den Nachteil auf, daß sie technisch lediglich dann realisierbar und wirtschaftlich sinnvoll sind, falls wenige Verbindungsleitungen bzw. Leiterbahnen benötigt werden und die Abstände zwischen den Verbindungen bzw. Leiterbahnen relativ groß sind.

### VORTEILE DER ERFINDUNG

Die erfindungsgemäße Steuergeräteeinheit mit den Merkmalen des Anspruchs 1 und das entsprechende Herstellungsverfahren derselben gemäß Anspruch 8 weisen gegenüber den bekannten Lösungsansätzen den Vorteil auf, daß eine Steuergeräteeinheit geschaffen wird, welche vollständig hermetisch abgedichtet ist und welche gleichzeitig eine Kontaktierung der im Gehäuse befindlichen Schaltung nach außen auf einfache Weise gewährleistet, wobei eine große Anzahl von Kontaktierungen ohne weiteres vorgesehen sein kann.

Ferner können die Kontaktierungen ein kleines Raster aufweisen, was den benötigten Bauraum verringert, und können relativ beliebig angeordnet werden. Zudem kann die erfindungsgemäße Steuergeräteeinheit auf einfache Weise und somit kostengünstig hergestellt werden.

Die der vorliegenden Erfindung zugrundeliegende Idee besteht darin, daß ein Dichtgel mit einer derartigen Viskosität in einer Ausnehmung im Rahmen der Steuergeräteeinheit vorgesehen ist, daß das Dichtgel die die Ausnehmung durchlaufenden elektrischen Leiterbahnen und eine in die Ausnehmung eingesetzte Anformung eines Deckels umfließen kann.

Somit wird mittels einer einzigen Dichtung sowohl eine Einzelabdichtung jeder Leiterbahn als auch eine Abdichtung zwischen der Bodenplatte und dem Deckel der Steuergeräteeinheit gewährleistet. Die geometrische Ausgestaltung der einzelnen Leiterbahnen ist dabei unerheblich, so daß beispielsweise bei Verwendung eines Stanzgitters für die Leiterbahnen Bruchkanten, Einschnürungen, etc. an den Stanzkanten ohne jeglicher Bedeutung für das Abdichtverhalten sind. Ferner ist keine besondere geometrische Genauigkeit der Leiterbahnen bzw. des Rasters zwischen den Leiterbahnen erforderlich. Eine einfache wirtschaftliche Fertigung ist somit möglich.

Aufgrund der beliebigen Anzahl und der beliebigen Verteilung der Leiterbahnen am bzw. im Gehäuserahmen ist eine leichtere Anpassung an die Vorgaben des Schaltungs-Layouts bzw. an die umgebenden baulichen Verhältnisse möglich.

Ferner können zusätzlich zum Schaltungsträger weitere elektronische Bauelemente im Gehäuse vorgesehen werden und mit dem Schaltungsträger bzw. nach außen kontaktiert werden. Somit kann teure Bauraumfläche in der Steuergeräteeinheit bzw. auf dem Schaltungsträger eingespart werden. Bauelemente, welche beispielsweise nicht auf dem Schaltungsträger angeordnet werden können, wie beispielsweise große Kondensatoren oder Bauelemente mit einer großen elektromagnetischen Strahlung oder Verlustleistung, können dennoch auf einfache Weise mit dem Schaltungsträger kontaktiert werden.

In den Unteransprüchen finden sich vorteilhafte Weiterbildungen und Verbesserungen der im Anspruch 1 angegebenen Steuergeräteeinheit sowie des im Anspruch 8 angegebenen Verfahrens zum Herstellen derselben.

Gemäß einer bevorzugten Weiterbildung ist das Dichtgel als Silikongel ausgebildet, welches nach einem etwaigen Aushärtungsvorgang seine elastischen Eigenschaften beibehält.

Gemäß einer weiteren bevorzugten Weiterbildung weist die Anformung des Deckels mindestens einen Aufnahmebereich zur Aufnahme einer bestimmten Menge des Dichtgels in einem zusammengedrückten Zustand der Steuergeräteeinheit auf. Somit kann das Dichtgel bei einer Krafteinwirkung in den Aufnahmebereich der Anformung eintreten und für eine bessere Abdichteigenschaft sorgen.

Vorzugsweise ist die Ausnehmung des Rahmens als umlaufende Nut ausgebildet. Demgemäß ist die Anformung des Deckels vorzugsweise als der Nut zugeordnete Feder ausgebildet, welche ebenfalls umlaufend angeordnet ist.

Der Deckel ist beispielsweise mittels einer Laser-Schweißung, einer Rastverbindung, einer Formfedereinrichtung oder dergleichen mit dem Rahmen fest verbindbar. Das bevorzugte Verbindungsmittel kann entsprechend der Anwendung der Steuergeräteeinheit bzw. dem Einsatzbereich der Steuergeräteeinheit ausgewählt werden.

Besonders vorteilhaft besteht die Bodenplatte aus einem Material mit einer guten Wärmeleitfähigkeit, beispielsweise aus Metall. Dadurch ist eine gute Wärmeabfuhr an eine mit der Bodenplatte verbundene Kühlfläche möglich.

Insbesondere sind die Leiterbahnen als Stanzgitter-Leiterbahnen oder als Flexfolien-Leiterbahnen ausgebildet. Allerdings ist eine andere Ausgestaltung der Leiterbahn ebenfalls denkbar, da durch das viskose Dichtgel jegliche geometrische Formen umflossen werden können.

Gemäß einer weiteren bevorzugten Weiterbildung wird die Steuergeräteeinheit mittels einer Federeinrichtung auf eine zugeordnete Fläche gedrückt. Diese Fläche kann beispielsweise die Trägerfläche eines Getriebegehäuses oder eine anderweitig ausgebildete Kühlfläche darstellen. Durch diese Kraftbeaufschlagung wird ein hydrostatischer Druck in dem Dichtgel erzeugt, welcher die Dichteigenschaft deutlich verbessert. Ferner wird der gesamte Aufbau der Steuergeräteeinheit unter der Krafteinwirkung zusammengehalten.

### ZEICHNUNGEN

Ausführungsbeispiele der Erfindung sind in den Zeichnungen dargestellt und in der nachfolgenden Beschreibung näher erläutert. In den Figuren zeigen:
- Figur 1: eine Unteransicht einer Steuergeräteeinheit gemäß dem Stand der Technik;
- Figur 2: eine Seitenquerschnittsansicht der Steuergeräteeinheit in Figur 1 entlang der Linie A- A;
- Figur 3: eine Draufsicht auf eine Steuergeräteeinheit gemäß einem ersten Ausführungsbeispiel der vorliegenden Erfindung bei abgenommenem Deckel;
- Figur 4: einen Ausschnitt einer Seitenquerschnittsansicht einer Steuergeräteeinheit gemäß einem zweiten Ausführungsbeispiel der vorliegenden Erfindung;
- Figur 5: einen Ausschnitt einer Seitenquerschnittsansicht einer Steuergeräteeinheit gemäß einem dritten Ausführungsbeispiel der vorliegenden Erfindung;
- Figur 6: einen Ausschnitt einer Seitenquerschnittsansicht einer Steuergeräteeinheit gemäß einem vierten Ausführungsbeispiel der vorliegenden Erfindung;
- Figur 7: eine Perspektivansicht der Formfedereinrichtung in Figur 6;
- Figur 8: einen Ausschnitt einer Seitenquerschnittsansicht eines Steuergerätes gemäß einem fünften Ausführungsbeispiel der vorliegenden Erfindung in einem ersten Zustand;
- Figur 9: einen Ausschnitt einer Seitenquerschnittsansicht eines Steuergerätes gemäß einem fünften Ausführungsbeispiel der vorliegenden Erfindung in einem zweiten Zustand;
- Figur 10: eine Seitenquerschnittsansicht einer Steuergeräteeinheit gemäß einem sechsten Ausführungsbeispiel der vorliegenden Erfindung;
- Figur 11: eine Draufsicht auf eine Steuergeräteeinheit gemäß einem siebten Ausführungsbeispiel der vorliegenden Erfindung bei abgenommenem Deckel; und
- Figur 12: eine Draufsicht auf eine Steuergeräteeinheit gemäß einem achten Ausführungsbeispiel der vorliegenden Erfindung bei abgenommenem Deckel.

### BESCHREIBUNG DER AUSFÜHRUNGSBEISPIELE

In den Figuren bezeichnen gleiche Bezugszeichen gleiche oder funktionsgleiche Komponenten.

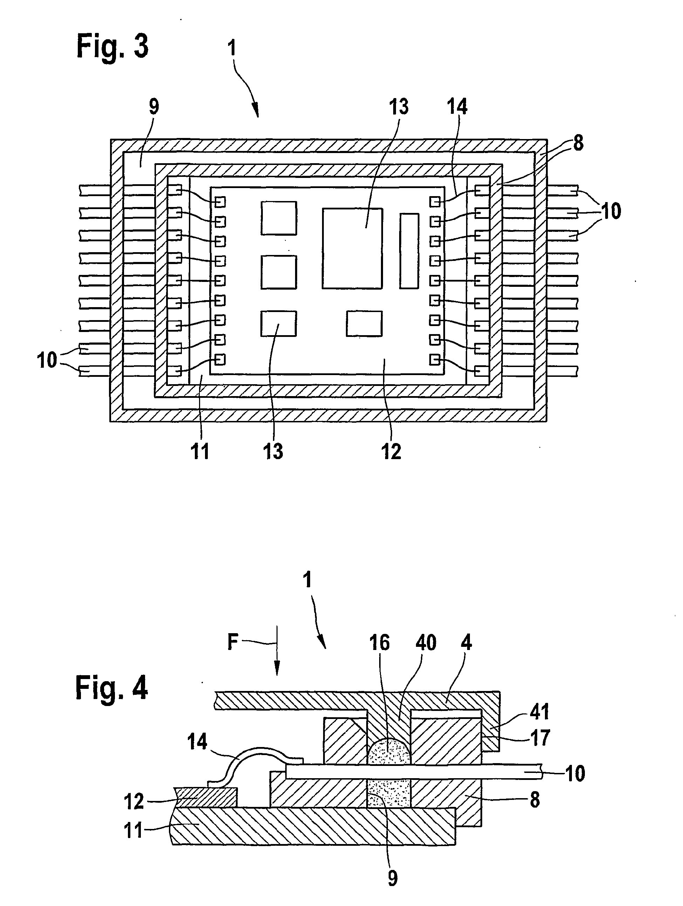

Figur 3 illustriert eine Draufsicht auf eine Steuergeräteeinheit 1 mit abgenommenem Deckel gemäß einem ersten Ausführungsbeispiel der vorliegenden Erfindung. Die Steuergeräteeinheit 1 weist einen Rahmen 8 auf, welcher vorzugsweise aus einem Kunststoff hergestellt ist und eine umlaufende Nut 9 umfaßt.

Leiterbahnen 10 sind vorzugsweise in den Kunststoff-Rahmen 8 eingespritzt und durchlaufen die Nut 9. Die Leiterbahnen 10 können beispielsweise als Stanzgitter-Leiterbahnen oder als Flexfolien-Leiterbahnen ausgebildet sein.

Ferner umfaßt die Steuergeräteeinheit 1 eine Bodenplatte 11, welche vorzugsweise aus einem Material mit guten Wärmeleiteigenschaften gebildet ist. Beispielsweise kann die Bodenplatte 11 aus Metall bestehen. Auf der Bodenplatte 11 ist ein Schaltungsträger 12, beispielsweise ein LTCC oder ein Hybrid, angeordnet, welcher mit elektronischen Bauelementen 13 ausgestattet ist. Der Schaltungsträger 12 wird mit den Leiterbahnen 10 mittels vorzugsweise einer Bond-Verbindung 14 elektrisch kontaktiert.

Die Steuergeräteeinheit 1 wird ferner mit einem Deckel (in Figur 3 nicht dargestellt) verschlossen, wobei zwischen dem Deckel, dem Rahmen 8 und der Bodenplatte 11 ein Dichtgel gefüllt wird. Dies wird im folgenden bei der Beschreibung der weiteren Figuren näher erläutert.

Figur 4 zeigt einen Teilausschnitt einer Seitenquerschnittsansicht einer Steuergeräteeinheit 1 gemäß einem zweiten Ausführungsbeispiel der vorliegenden Erfindung. Wie in Figur 4 ersichtlich ist, verlaufen die Leiterbahnen 10 durch die im Rahmen 8 vorgesehene umlaufende Nut 9. Ein Dichtgel 16, welches später näher beschrieben wird, wird in die Nut 9 gefüllt. Der Deckel 4 weist eine der Nut 9 zugeordnete Feder bzw. Anformung 40 auf, welche ebenfalls vorzugsweise umlaufend ausgebildet ist. Die Anformung 40 ist derart als Feder ausgebildet, daß sie beim Aufsetzen des Deckels 4 auf dem Rahmen 8 in die zugeordnete Nut 9 formschlüssig einsetzbar ist. Beispielsweise weist die Anformung 40 des Deckels 4 an seinem freien Ende eine Form auf, welche zwei Dichtlippen entspricht. Somit wird ein Austreten des Dichtgels 16 zwischen dem Rahmen 8 und dem Deckel 4 zusätzlich vermieden.

Im folgenden werden die einzelnen Verfahrensschritte zur Herstellung der Steuergeräteeinheit 1 exemplarisch erläutert. Zunächst wird die Bodenplatte 11 in den Rahmen 8 eingepreßt und/oder eingeklebt.

Anschließend wird der Schaltungsträger 12 auf die Bodenplatte 11 geklebt und mit elektronischen Bauelementen (nicht dargestellt) bestückt. Eine Bestückung mit elektronischen Bauelementen kann auch vor einer Montierung des Schaltungsträgers 12 auf der Bodenplatte 11 erfolgen.

Danach erfolgt eine Kontaktierung des Schaltungsträgers 12 mit den Leiterbahnen 10, wobei eine derartige Kontaktierung vorzugsweise mittels einer Bond-Verbindung 14 bewerkstelligt wird.

Anschließend wird in die umlaufende Nut 9 des Rahmens 8 ein Dichtgel 16 eingegossen, wobei das Dichtgel 16 eine derartige Viskosität aufweist, daß die durch die Nut 9 verlaufenden Leiterbahnen 10 von dem Dichtgel 16 umflossen werden. Das Dichtgel 16 ist vorzugsweise aus einem Material hergestellt, welches nach einem etwaigen Aushärtvorgang seine elastischen Eigenschaften beibehält. Beispielsweise besteht das Dichtgel 16 aus Silikon.

Im Anschluß daran wird der Deckel 4, welcher ebenfalls vorzugsweise ein Kunststoff-Spritzteil darstellt, mittels seiner Anformung 40 in die Nut 9 des Rahmens 8 eingesetzt und vorzugsweise mit einer vorbestimmten Kraft F in in Figur 4 dargestellter Pfeilrichtung derart beaufschlagt, daß sich im Dichtgel ein hydrostatischer Druck aufbaut, welcher die für die Dichtheit der Anordnung erforderliche Anpressung darstellt.

Für eine Beaufschlagung des Deckels 4 mit der Kraft F sind mehrere Varianten vorstellbar. Gemäß dem zweiten Ausführungsbeispiel der vorliegenden Erfindung, wie in Figur 4 dargestellt, kann der Deckel 4 mit dem Rahmen 8 mittels einer Laser-Schweißverbindung 17 verbunden werden. Dafür weist der Deckel 4 einen in Richtung der Bodenplatte 11 umgebogenen Randabschnitt 41 auf, dessen innere Fläche an einer äußeren Fläche des Rahmens 8 anliegt und die bevorzugte Schweißstelle darstellt.

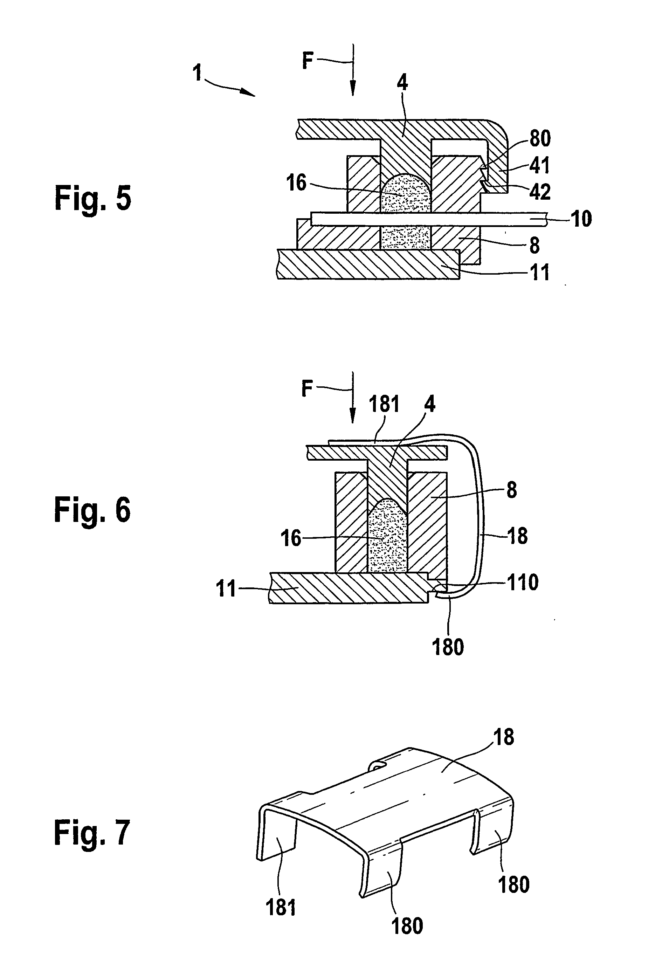

Figur 5 zeigt einen Ausschnitt einer Seitenquerschnittsansicht einer Steuergeräteeinheit 1 gemäß einem dritten Ausführungsbeispiel der vorliegenden Erfindung. Hierbei weist der Randabschnitt 41 des Deckels 4 Rastnasen 42 auf, welche vorzugsweise in mehrfach gestaffelte Verrastungen 80 an der dem Randabschnitt 41 zugeordneten Fläche des Rahmens 8 eingreifen können.

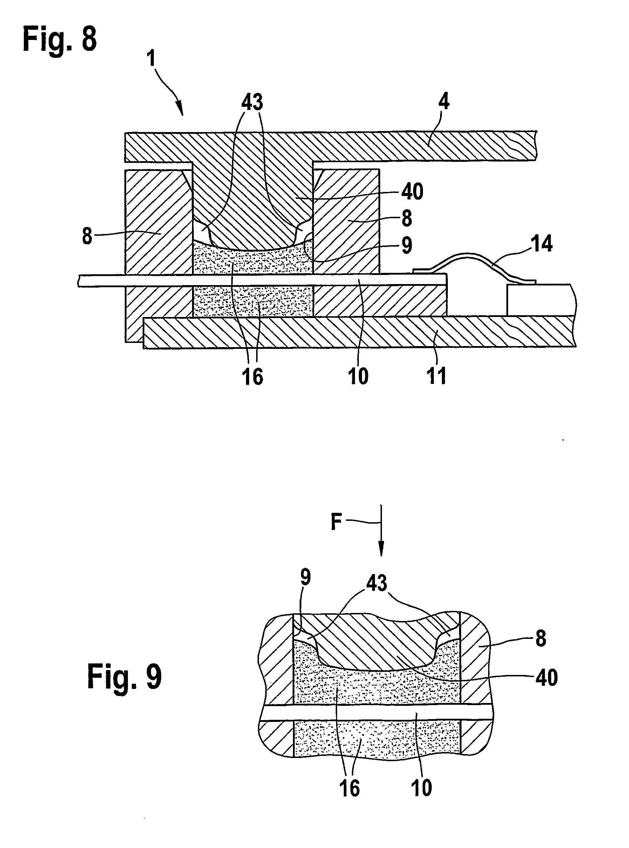

In Figur 6 ist ein Teilausschnitt einer Seitenquerschnittsansicht einer Steuergeräteeinheit 1 gemäß einem vierten Ausführungsbeispiel der vorliegenden Erfindung dargestellt. Hierbei wird die Andrückkraft F mittels einer Formfedereinrichtung 18 bewerkstelligt, welche beispielsweise die in Figur 8 in perspektivischer Ansicht dargestellte Ausgestaltung aufweist. Die Formfedereinrichtung 18 besteht vorzugsweise aus Metall und weist eine Vorspannung in Richtung der Längsachse der Formfedereinrichtung 18 auf. Die Formfedereinrichtung 18 besitzt beispielsweise ein Paar kürzer ausgebildete Rasthaken 180 und ein Paar länger ausgebildeter Rasthaken 181. Im eingebauten Zustand befinden sich beispielsweise die kürzeren Rasthaken 180 in Eingriff mit einem Absatz 110 der Bodenplatte 11 und die längeren Rasthaken 181 in Anlage mit der Oberfläche des Deckels 4. Dadurch wird der Deckel 4 mittels der metallischen Formfedereinrichtung 18 in Richtung Bodenplatte 11 mit einer vorbestimmten Kraft F gedrückt. Es ist vorteilhaft, die Form für die seitliche Fixierung der Formfedereinrichtung 18 an der Bodenplatte 11 mittels Strangpressen der Bodenplatte 11 herzustellen.

Die Figuren 8 und 9 illustrieren einen Teilausschnitt einer Seitenquerschnittsansicht einer Steuergeräteeinheit 1 gemäß einem fünften Ausführungsbeispiel der vorliegenden Erfindung in einem ersten und einen zweiten Zustand.

In Figur 8 ist die Anformung 40 bzw. die Feder 40 des Deckels 4 in die Nut 9 derart eingesetzt, daß die Stirnfläche der Anformung 40 in Kontakt mit dem Dichtgel 16 gelangt. Die Anformung 40 weist gemäß diesem Ausführungsbeispiel mindestens einen Aufnahmebereich 43 auf, welcher vorzugsweise als umlaufende Materialaussparung ausgebildet ist, wodurch sich bei einer Krafteinwirkung F auf den Deckel 4 in Richtung des Pfeils in Figur 9 ein hydrostatischer Druck in dem Dichtgel 16 ausbildet und das Dichtgel 16 zum Teil in das durch die Ausnehmungen 43 gebildete Volumen gedrückt wird, wie in Figur 9 dargestellt ist. Dadurch kann eine verbesserte Dichteigenschaft der Anordnung erreicht werden.

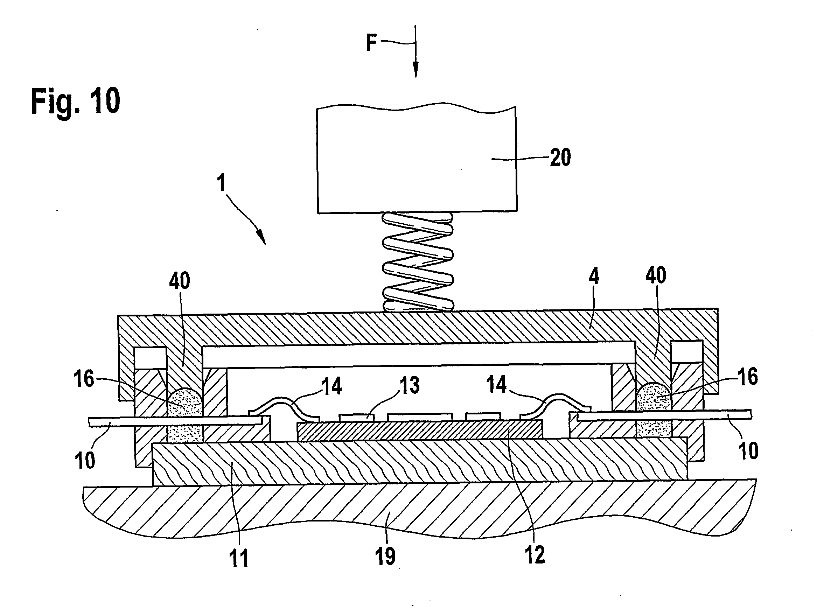

Figur 10 illustriert eine Seitenquerschnittsansicht einer Steuergeräteeinheit 1 gemäß einem sechsten Ausführungsbeispiel der vorliegenden Erfindung. Da die Steuergeräteeinheit 1 beispielsweise in einem Automatikgetriebe im Kraftfahrzeugbereich eingesetzt werden soll, in welchem äußerst hohe Betriebstemperaturen herrschen, ist eine Kontaktkühlung für die Steuergeräteeinheit 1 vorteilhaft. Aus diesem Grunde kann die Steuergeräteeinheit 1 mit der vorzugsweise metallischen Bodenplatte 11 auf einer Kühlfläche 19 in beispielsweise einem Getriebegehäuse montiert werden. Für den entsprechenden Anpreßdruck ist beispielsweise eine Federeinrichtung 20 vorgesehen, wodurch der Deckel 4 auf die Bodenplatte 11 gedrückt wird, wodurch das Dichtgel 16 im Kraftfluß der Federeinrichtung 20 liegt. Ferner kann somit zusätzlich auf eine aufwendige Fixierung der Bodenplatte 11 im Rahmen 8 verzichtet werden.

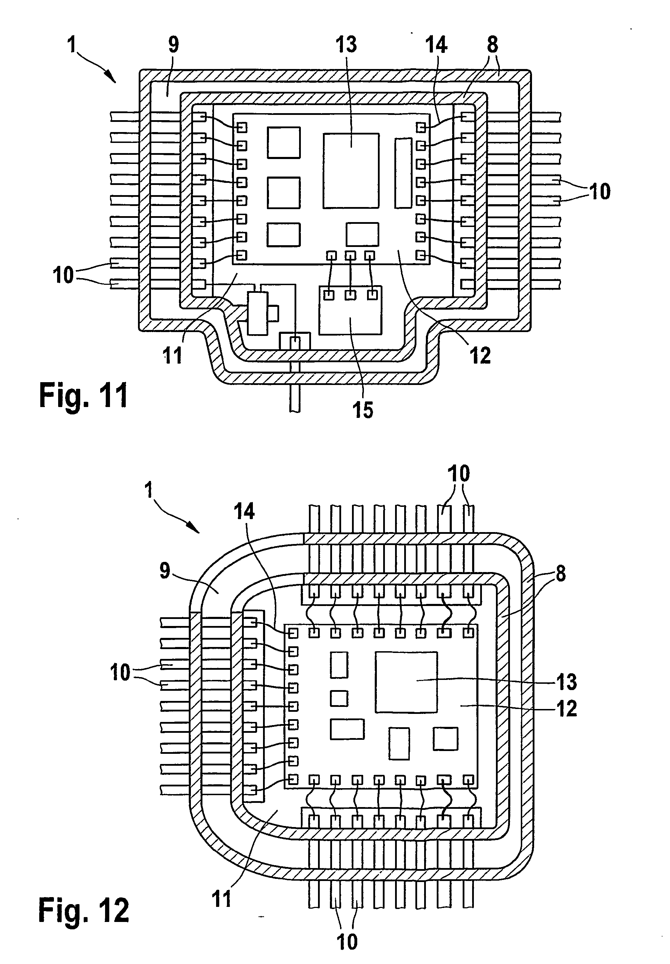

In Figur 11 ist eine Draufsicht auf eine Steuergeräteeinheit 1 gemäß einem siebten Ausführungsbeispiel der vorliegenden Erfindung, ohne aufgesetztem Deckel dargestellt. Es ist ersichtlich, daß die Form der Steuergeräteeinheit 1 jede zweckmäßige Form annehmen kann, um die notwendigen elektronischen Bauelemente und Schaltungen im Innenbereich platzieren zu können. Der Deckel mit seiner zugehörigen Anformung ist entsprechend der jeweiligen Nut derart auszubilden, daß ein formschlüssiger Einsatz des Deckels in die Nut 9 gewährleistet ist.

Ferner ist es durch eine bestimmte räumliche Ausgestaltung der Steuergeräteeinheit 1 möglich, zusätzlich zum Schaltungsträger weitere elektronische Bauelemente 15, wie in Figur 11 dargestellt ist, im Gehäuse unterzubringen und zum Schaltungsträger oder nach außen hin zu kontaktieren. Hierdurch kann ein zusätzlicher Vorteil erreicht werden, da teure Fläche auf dem Schaltungsträger eingespart wird und Bauelemente eingesetzt werden können, die nicht auf dem Schaltungsträger aufgrund ihrer Abmessungen oder ihrer zu hohen elektromagnetischen Strahlungen bzw. Verlustleistungen gebaut werden können.

Figur 12 illustriert eine Draufsicht auf eine Steuergeräteeinheit 1 ohne aufgesetztem Deckel gemäß einem achten Ausführungsbeispiel der vorliegenden Erfindung. Es ist für einen Fachmann selbstverständlich, daß die Leiterbahnen 10 lediglich an einer Seite bzw. an mehreren Seiten des Rahmens 8 angeordnet sein können, entsprechend der jeweiligen Anwendungsfunktion.

Obwohl die vorliegende Erfindung anhand bevorzugter Ausführungsbeispiele vorstehend beschrieben wurde, ist sie darauf nicht beschränkt, sondern auf vielfältige Weise modifizierbar.

Die vorliegende Erfindung schafft somit eine Steuergeräteeinheit und ein Verfahren zur Herstellung derselben, welche eine hermetische Abdichtung des Innenraumes, in welchem die Schaltungsträger und die zugehörigen elektronischen Bauelemente angeordnet sind, liefert. Die Steuergeräteeinheit ist derart ausgestaltet, daß mittels einer einzigen Dichtung, nämlich mittels dem Dichtgel, eine Einzelabdichtung für jede Leiterbahn als auch eine Abdichtung gegen die Bodenplatte und den Deckel gewährleistet wird. Dadurch ist die genaue geometrische Ausgestaltung der einzelnen Leiterbahnen unerheblich, d.h. Bruchkanten, Einschnürungen, etc. an den Stanzkanten sind ohne jeglicher Bedeutung, da das Dichtgel mit einer vorbestimmten Viskosität die Leiterbahnen mit jeglicher Form umfließt. Somit ist eine einfache, wirtschaftliche Fertigung eines hermetisch abgedichteten Steuergerätes möglich.

Die Anzahl und die Verteilung der einzelnen Leiterbahnen am Gehäuserahmen kann dadurch beliebig ausgestaltet werden, so daß eine leichte Anpassung an die Vorgabe des Schaltungs-Layouts bzw. an die umgebenden baulichen Verhältnisse möglich ist.

## Patentansprüche

1. Steuergeräteeinheit (1), insbesondere im Kraftfahrzeugbereich, mit:
einem Rahmen (8), welcher eine von elektrischen Leiterbahnen (10) für eine elektrische Versorgung durchlaufene Ausnehmung (9) aufweist;
einer Bodenplatte (11), welche in den Rahmen (8) eingesetzt ist;
einem Schaltungsträger (12), welcher elektronische Bauelemente trägt und auf der Bodenplatte (11) angebracht ist;
einer elektrischen Verbindung (14) zum Verbinden des Schaltungsträgers (12) mit den Leiterbahnen (10); und mit
einem Deckel (4) für einen hermetischen Verschluß der Steuergeräteeinheit (1), welcher eine in die zugeordnete Ausnehmung (9) im Rahmen (8) einsetzbare Anformung (40) aufweist;
**dadurch gekennzeichnet, daß**
ein Dichtgel (16) mit einer derartigen Viskosität in der Ausnehmung (9) vorgesehen ist, daß das Dichtgel (16) die die Ausnehmung (9) durchlaufenden elektrischen Leiterbahnen (10) umfließen kann.

2. Steuergeräteeinheit nach Anspruch 1,
**dadurch gekennzeichnet, daß**
das Dichtgel (16) als Silikongel ausgebildet ist, welches nach einem etwaigen Aushärtungsvorgang elastisch bleibt.

3. Steuergeräteeinheit nach Anspruch 1 oder 2,
**dadurch gekennzeichnet, daß**
die Anformung (40) des Deckels (4) mindestens einen Aufnahmebereich (43) zur Aufnahme von Dichtgel in einem zusammengedrückten Zustand aufweist.

4. Steuergeräteeinheit nach wenigstens einem der vorhergehenden Ansprüche,
**dadurch gekennzeichnet, daß**
die Ausnehmung (9) des Rahmens (4) als umlaufende Nut (9) und die Anformung (40) des Deckels (4) als der Nut (9) zugeordnete Feder (40) ausgebildet ist.

5. Steuergeräteeinheit nach wenigstens einem der vorhergehenden Ansprüche,
**dadurch gekennzeichnet, daß**
der Deckel (4) mit dem Rahmen (8) mittels einer Laser-Schweißung (17), einer Rastverbindung (41, 42), einer Formfedereinrichtung (18) oder dergleichen verbindbar ist.

6. Steuergeräteeinheit nach wenigstens einem der vorhergehenden Ansprüche,
**dadurch gekennzeichnet, daß**
die Bodenplatte (11) aus einem Material mit einer guten Wärmeleitfähigkeit, beispielsweise aus Metall, hergestellt ist.

7. Steuergeräteeinheit nach wenigstens einem der vorhergehenden Ansprüche,
**dadurch gekennzeichnet, daß**
die Leiterbahnen (10) als Stanzgitter-Bahnen oder als Flexfolien-Bahnen ausgebildet sind.

8. Verfahren zum Herstellen einer Steuergeräteeinheit (1), welche gemäß einem der Ansprüche 1 bis 7 ausgebildet ist, mit folgenden Schritten:
Einpressen und/oder Einkleben einer Bodenplatte (11) in einen Rahmen (8), welcher eine Ausnehmung (9) aufweist, welche von elektrischen Leiterbahnen (10) für eine elektrische Versorgung durchlaufen wird;
Kleben eines Schaltungsträgers (12), welcher für ein Tragen von elektronischen Bauelementen (13) vorgesehen ist, auf die Bodenplatte (11);
Kontaktieren des Schaltungsträgers (12) mit den elektrischen Leiterbahnen (10) mittels beispielsweise einem Bond-Verfahren;
Eingießen eines Dichtgels (16) in die in dem Rahmen (8) vorgesehene Ausnehmung (9), wobei das Dichtgel (16) eine derartige Viskosität aufweist, daß es die die Ausnehmung (9) durchlaufenden elektrischen Leiterbahnen (10) umfließen kann;
Einsetzen eines mit einer Anformung (40) ausgestalteten Deckels (4) in die mit dem Dichtgel (16) gefüllte Ausnehmung (9) des Rahmens (8) für einen hermetischen Verschluß der Steuergeräteeinheit (1), und
Beaufschlagen des Deckels (4) mit einer vorbestimmten Kraft für einen Aufbau eines hydrostatischen Druckes im Dichtgel (16).

9. Verfahren nach Anspruch 8,
**dadurch gekennzeichnet, daß**
die Bodenplatte (11) aus Metall ausgebildet wird und auf einer Kühlfläche (19) in Anlage mit derselben montiert wird.

10. Verfahren nach einem der Ansprüche 8 oder 9,
**dadurch gekennzeichnet, daß**
die Steuergeräteeinheit (1) mittels einer Federeinrichtung (20) mit einer vorbestimmten Kraft beaufschlagt wird.

## Claims

1. Control unit (1), in particular in the field of motor vehicles, having:
a frame (8) which has a recess (9) through which electrical conductor tracks (10) for supplying electricity run;
a base plate (11) which is inserted into the frame (8);
a circuit carrier (12) which is fitted with electronic components and is mounted on the base plate (11);
an electrical connection (14) for connecting the circuit carrier (12) to the conductor tracks (10); and having
a cover (4) for hermetically sealing the control unit (1), which cover (4) has a protrusion (40) which can be inserted into the assigned recess (9) in the frame (8);
**characterized in that**
a sealing gel (16) with such a viscosity that the sealing gel (16) can flow around the electrical conductor tracks (10) which run through the recess (9) is provided in the recess (9).

2. Control unit according to Claim 1,
**characterized in that**
the sealing gel (16) is embodied as a silicone gel which remains elastic after any hardening process.

3. Control unit according to Claim 1 or 2,
**characterized in that**
the protrusion (40) of the cover (4) has at least one receptacle area (43) for receiving sealing gel in a pressed-together state.

4. Control unit according to at least one of the preceding claims,
**characterized in that**
the recess (9) in the frame (4) is embodied as a circumferential groove (9), and the protrusion (40) of the cover (4) is embodied as a spring (40) assigned to the groove (9).

5. Control unit according to at least one of the preceding claims,
**characterized in that**
the cover (4) can be connected to the frame (8) by means of a laser weld (17), a latching connection (41, 42), a shaped spring device (18) or the like.

6. Control unit according to at least one of the preceding claims,
**characterized in that**
the base plate (11) is manufactured from a material with good thermal conductivity, for example from metal.

7. Control unit according to at least one of the preceding claims,
**characterized in that**
the conductor tracks (10) are embodied as punched grid tracks or as flexible foil tracks.

8. Method for manufacturing a control unit (1) which is embodied according to one of Claims 1 to 7, having the following steps:
pressing and/or bonding of a base plate (11) into a frame (8) which has a recess (9) through which electrical conductor tracks (10) for supplying electricity run;
bonding of a circuit carrier (12), provided for bearing electronic components (13), onto the base plate (11);
formation of contact between the circuit carrier (12) and the electrical conductor tracks (10) by means of a bonding method, for example;
pouring of a sealing gel (16) into the recess (9) which is provided in the frame (8), wherein the sealing gel (16) has such a viscosity that it can flow around the electrical conductor tracks (10) which run through the recess (9);
insertion of a cover (4), configured with a protrusion (40), into the recess (9), filled with the sealing gel (16), in the frame (8) for hermetically sealing the control unit (1), and
application of a predetermined force to the cover (4) in order to build up a hydrostatic pressure in the sealing gel (16).

9. Method according to Claim 8,
**characterized in that**
the base plate (11) is formed from metal and is mounted on a cooling surface (19) in abutment therewith.

10. Method according to one of Claims 8 or 9,
**characterized in that**
a predetermined force is applied to the control unit (1) by means of a spring device (20).

## Revendications

1. Unité d'appareil de commande (1), notamment dans le domaine automobile, comprenant :
un cadre (8), qui présente un évidement (9) traversé par des pistes conductrices électriques (10) pour une alimentation électrique ;
une plaque de fond (11), qui est insérée dans le cadre (8) ;
un support de circuit (12) qui porte des composants électroniques et qui est monté sur la plaque de fond (11) ;
une connexion électrique (14) pour connecter le support de circuit (12) aux pistes conductrices (10) ; et
un couvercle (4) pour une fermeture hermétique de l'unité d'appareil de commande (1), qui présente une formation (40) pouvant être insérée dans l'évidement associé (9) dans le cadre (8) ;
**caractérisée en ce**
**qu'**un gel d'étanchéité (16) est prévu dans l'évidement (9), avec une viscosité telle que le gel d'étanchéité (16) puisse circuler autour des pistes conductrices électriques (10) traversant l'évidement (9).

2. Unité d'appareil de commande selon la revendication 1,
**caractérisée en ce que**
le gel d'étanchéité (16) est réalisé sous forme de gel de silicone, qui reste élastique après une opération de durcissement quelconque.

3. Unité d'appareil de commande selon la revendication 1 ou 2,
**caractérisée en ce que**
la formation (40) du couvercle (4) présente au moins une région de réception (43) pour recevoir un gel d'étanchéité dans un état comprimé.

4. Unité d'appareil de commande selon au moins l'une quelconque des revendications précédentes,
**caractérisée en ce que**
l'évidement (9) du cadre (8) est réalisé sous forme de rainure périphérique (9) et la formation (40) du couvercle (4) est réalisée sous forme de languette élastique (40) associée à la rainure (9).

5. Unité d'appareil de commande selon au moins l'une quelconque des revendications précédentes,
**caractérisée en ce que**
le couvercle (4) peut être connecté au cadre (8) au moyen d'un soudage au laser (17), d'une connexion par encliquetage (41, 42), d'un dispositif de ressort de formage (18) ou similaire.

6. Unité d'appareil de commande selon au moins l'une quelconque des revendications précédentes,
**caractérisée en ce que**
la plaque de fond (11) est fabriquée en un matériau ayant une bonne conductibilité thermique, par exemple en métal.

7. Unité d'appareil de commande selon au moins l'une quelconque des revendications précédentes,
**caractérisée en ce que**
les pistes conductrices (10) sont réalisées sous forme de pistes en grille estampée ou sous forme de pistes en film flexible.

8. Procédé de fabrication d'une unité d'appareil de commande (1) réalisée selon l'une quelconque des revendications 1 à 7, comprenant les étapes suivantes :
presser et/ou coller une plaque de fond (11) dans un cadre (8), qui présente un évidement (9) qui est traversé par des pistes conductrices électriques (10) pour une alimentation électrique ;
coller un support de circuit (12), qui est prévu pour porter des composants électroniques (13), sur la plaque de fond (11) ;
mettre en contact le support de circuit (12) avec les pistes conductrices électriques (10) au moyen d'un procédé de liaison, par exemple ;
verser un gel d'étanchéité (16) dans l'évidement (9) prévu dans le cadre (8), le gel d'étanchéité (16) présentant une viscosité telle que le gel d'étanchéité (16) puisse circuler autour des pistes conductrices électriques (10) traversant l'évidement (9) ;
insérer un couvercle (4) configuré avec une formation (40) dans l'évidement (9) du cadre (8) rempli du gel d'étanchéité (16), pour assurer une fermeture hermétique de l'unité d'appareil de commande (1), et
solliciter le couvercle (4) avec une force prédéterminée pour créer une pression hydrostatique dans le gel d'étanchéité (16).

9. Procédé selon la revendication 8,
**caractérisé en ce que**
la plaque de fond (11) est réalisée en métal et est montée sur une surface de refroidissement (19) en appui avec celle-ci.

10. Procédé selon l'une quelconque des revendications 8 ou 9,
**caractérisé en ce que**
l'unité d'appareil de commande (1) est sollicitée avec une force prédéterminée au moyen d'un dispositif à ressort (20).
